# FASCICULE DE BREVET EUROPEEN

(11) **EP 2 553 724 B1**
(45) Date de publication et mention de la délivrance du brevet: **23.03.2016**
(21) Numéro de dépôt: 11715987.1
(22) Date de dépôt: 24.03.2011
(51) Int. Cl.: H01L 27/142, H01L 31/02, H01L 31/05, H01L 31/0392, H01L 31/18

(54) **FABRICATION D'UN MODULE PHOTOVOLTAIQUE COMPORTANT UN ENSEMBLE DE CELLULES**
HERSTELLUNG EINES PHOTOVOLTAISCHEN MODULS MIT ZELLANORDNUNG
MANUFACTURE OF PHOTOVOLTAIC MODULE COMPRISING CELL ASSEMBLY

(30) Priorité: 26.03.2010 FR 1052225
(43) Date de publication de la demande: 06.02.2013
(73) Titulaire: Nexcis, 13106 Rousset (FR)
(72) Inventeur: DUNNE, Brendan, F-13120 Gardanne (FR)
(74) Mandataire: Cabinet Plasseraud
(86) Numéro de dépôt international: PCT/FR2011/050632
(87) Numéro de publication internationale: WO 2011/117548

(56) Documents cités:
- EP-A2- 2 101 357
- US-A- 4 612 408
- US-A- 4 754 544
- US-A- 5 391 236
- US-A1- 2008 227 236

## Description

La présente invention concerne la fabrication d'un module photovoltaïque comportant un ensemble de cellules photovoltaïques.

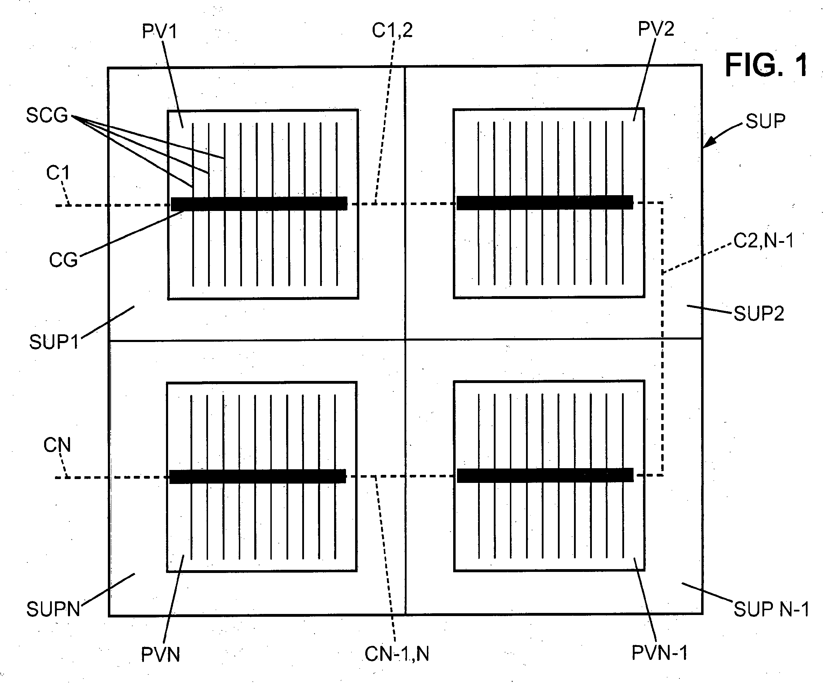

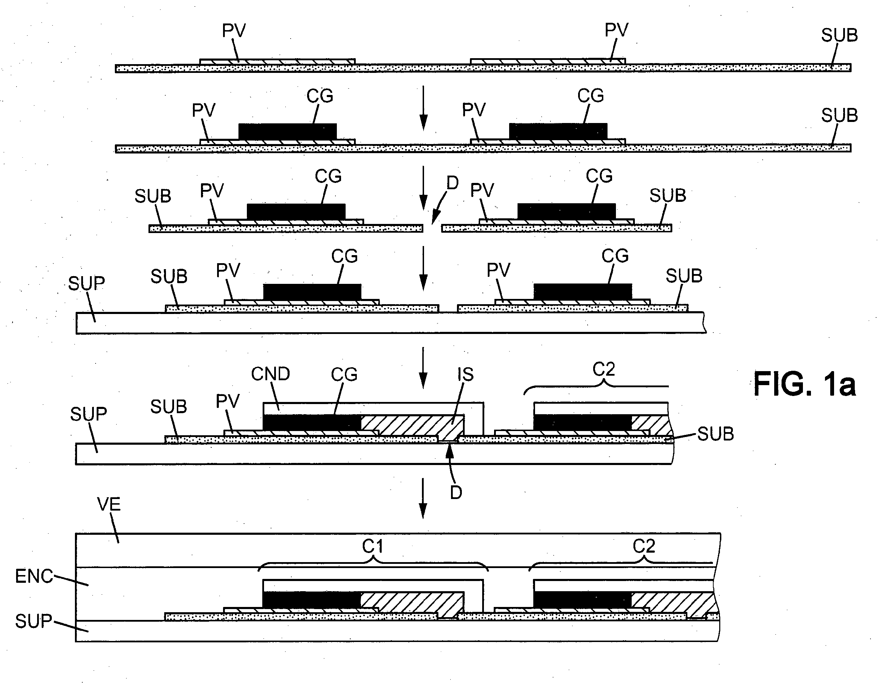

En référence à la figure 1 représentant un ensemble de cellules photovoltaïques, chaque cellule présente une partie active PV1, PV2, ..., PVN-1, PVN, reposant sur un support respectif SUP1, SUP2, ..., SUPN-1, SUPN. Typiquement, la partie active de chaque cellule correspond à une photodiode présentant un empilement de couches telles que par exemple :
- une couche d'adaptation avec un substrat (souvent en verre, ou sous forme de feuille métallique), cette couche d'adaptation étant de molybdène par exemple,
- une couche active, proprement dite, et à propriétés photovoltaïques (par exemple un composé I-III-VI₂ de type Cuivre-(Indium, Gallium et/ou Aluminium)-(Soufre et/ou Sélénium), ou encore un composé à base de tellure de cadmium, ou encore de silicium amorphe),
- et souvent des couches supplémentaires (transparentes pour laisser la lumière interagir avec la couche sous-jacente à propriétés photovoltaïques), de sulfure de cadmium, d'oxyde de zinc, etc.

La partie active de chaque cellule est appelé ici, de façon générale, « film photovoltaïque ».

Il est prévu en outre de déposer sur ce film, et ce sélectivement de manière encore à ne pas cacher de la lumière le film photovoltaïque, une grille de collecte SCG des charges générées par effet photovoltaïque et issues du film photovoltaïque. Ainsi, la grille de collecte présente :
- des dépôts (représentés sur la figure 1 sous forme de traits, par exemple sérigraphiés) sur la surface supérieure du film photovoltaïque de la cellule pour récupérer les électrons générés par effet photovoltaïque, et
- un collecteur principal CG relié à ces dépôts SCG pour collecter globalement « l'électricité » générée par la partie active PV1.

Ainsi, la forme de la grille de collecte SCG et du collecteur CG est un compromis entre le nombre de photons incidents sur le film photovoltaïque et le nombre d'électrons effectivement collectés. Ci-après, la grille de collecte SCG et le collecteur CG d'une cellule sont communément désignés par les termes généraux « grille de collecte ».

Habituellement, les cellules photovoltaïques sont préparées sur un substrat commun, puis le substrat est découpé en autant de cellules individuelles. On procède ensuite à une étape de création des connexions de chaque cellule et d'interconnexion des cellules entre elles, par exemple par les connexions en série C1,2 ; C2,N-1 ; CN-1,N représentées sur la figure 1 à titre d'exemple. Pour cette étape, on assemble à nouveau les cellules photovoltaïques valides (étant entendu qu'un test de leur fonctionnement est mis en oeuvre préalablement) sur un support commun SUP (en verre ou en matériau polymère) et les connexions précitées sont ensuite créées. Le module photovoltaïque ainsi obtenu peut être connecté ensuite à une entrée (par la connexion C1) et à une sortie (par la connexion CN).

On se réfère à la figure la pour décrire plus en détail les étapes successives d'un procédé de fabrication d'un ensemble de cellules C1, C2 au sens de l'art antérieur. Des films photovoltaïques PV, propres chacun à une future cellule C1, C2, sont obtenus sur un substrat SUB (par exemple par dépôt sélectif d'un film photovoltaïque, en des régions du substrat destinées à former les cellules, ou encore par gravure sélective du film déposé, ou encore par tout autre moyen connu). On applique sur chaque film PV le dépôt d'une couche de collecte CG à une étape ultérieure. Puis, le substrat est découpé (référence D) pour former de futures cellules individuelles. Les découpes individuelles sont collées ensuite sur un support commun SUP. Il est procédé ensuite à l'application d'un film isolant IS, adjacent à la couche de collecte CG et recouvrant la zone de séparation D entre cellules, comme représenté sur la figure 1a. Enfin, un film conducteur CND est appliqué pour établir une connexion entre la face avant du film photovoltaïque PV, via la couche de collecte CG, et la face arrière du film photovoltaïque PV de la cellule adjacente C2, via son substrat SUB. Dans cet exemple de réalisation, on comprendra que le substrat SUB est conducteur, par exemple métallique. Le procédé peut se poursuivre ensuite par une étape d'encapsulation de la face avant du support SUP (portant les cellules C1, C2 ainsi finalisées et interconnectées) avec par exemple une plaque protectrice VE (par exemple de verre) collée sur la face avant avec le matériau d'encapsulation ENC.

Toutefois, un tel procédé de découpe et d'interconnexion des cellules est long et coûteux industriellement.

On connait en outre un procédé selon le document US N° 4,754,544. Toutefois, ce procédé ne permet pas de s'assurer qu'un film photovoltaïque ne sait pas court-circuité par un chemin électrique direct dans un substrat métallique.

La présente invention vient améliorer la situation.

Elle propose alors de conserver sur un même support les films photovoltaïques précités de chaque cellule, ce support pouvant correspondre au substrat d'origine des films photovoltaïques. Comme on le verra dans des exemples de réalisation décrits plus loin, le substrat peut être découpé mais, en particulier, les cellules ne sont pas désassociées, c'est-à-dire que leurs films photovoltaïques ne sont pas déplacés les uns par rapport aux autres dans le déroulement du procédé au sens de l'invention, et ce jusqu'à l'étape d'interconnexion des cellules.

A cet effet, la présente invention vise tout d'abord un procédé de fabrication d'un panneau de cellules photovoltaïque selon la revendication 1. Le procédé comporte les étapes:
a) obtention de films photovoltaïques destinés chacun à une cellule, disposés sur une face avant d'un substrat métallique,
b) application d'au moins un film conducteur (par exemple une couche de collecte, telle qu'une grille de collecte) sur chaque face avant d'un film photovoltaïque,
c) découpe du substrat pour isoler des cellules les unes des autres,
d) encapsulation des cellules sur un support commun,

Au sens de l'invention, les étapes d) et c) sont inversées, l'étape d) visant une encapsulation de la face avant du substrat, avant la découpe du substrat par sa face arrière à l'étape c). En outre :
- à l'étape b), une zone du film conducteur se prolonge sur le substrat de sorte que le film conducteur est en contact à la fois avec la face avant du film photovoltaïque et la face avant du substrat,
les films photovoltaïques des cellules étant ainsi court-circuités entre eux par le substrat métallique à cette étape b), et
- à l'étape c), le substrat est découpé pour dé-court-circuiter les films photovoltaïques entre eux, au moins sous la zone précitée du film conducteur et sur une largeur de substrat inférieure à la largeur de la zone.

La zone précitée de film conducteur, combinée au substrat, relie alors électriquement la face avant du film photovoltaïque à la face arrière d'un film photovoltaïque d'une cellule adjacente.

Ainsi, le procédé au sens de l'invention permet de conserver sur un même support (substrat, puis encapsulation de la face avant) les cellules tout au long de leur fabrication, ce qui permet alors d'éviter leur séparation mécanique les unes des autres, puis leur solidarisation à nouveau sur un support commun ensuite.

Le film conducteur précité peut avantageusement comporter une grille de collecte de charges issues du film photovoltaïque, laquelle est alors appliquée sur la face avant du film photovoltaïque et se prolonge sur la face avant du substrat (en la zone précitée).

Optionnellement et non nécessairement, on peut prévoir que le film conducteur comporte en outre un ruban conducteur appliqué sur la grille de collecte en recouvrant la zone précitée de la grille de collecte pour être en contact avec la face avant du substrat.

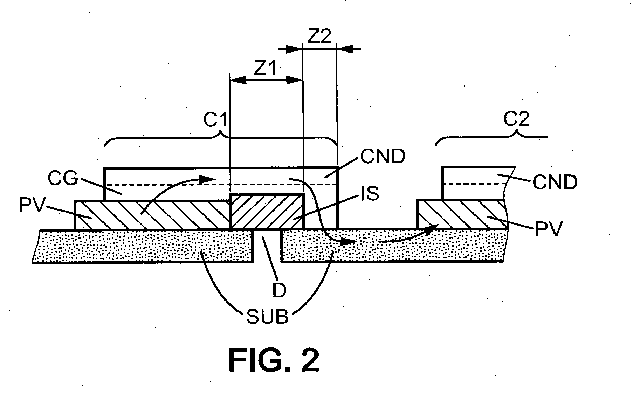

Comme on le verra plus en détail ci-après en référence à la figure 2, le film photovoltaïque (portant la référence PV sur cette figure 2) est recouvert au moins partiellement par le film conducteur (CND, CG). En particulier, le film conducteur s'étend au-delà du film photovoltaïque (PV) sur une première zone (Z1) et une deuxième zone consécutive (Z2) (la deuxième zone étant plus espacée du film photovoltaïque que la première zone). Ainsi :
- la deuxième zone (Z2) recouvre la face avant du substrat (SUB) en étant en contact avec celui-ci, et
- le substrat (SUB) est découpé en présentant un espace « vide » (D), appelé aussi ci-après « découpe (D) » sous la première zone (Z1).

On prévoit aussi un film isolant (IS), appliqué avant l'étape b), et:
- adjacent au film photovoltaïque (PV) et d'épaisseur supérieure à celle du film photovoltaïque, et
- destiné à être situé au-dessus de la découpe (D) du substrat et sous une partie de la zone d'extension (Z1) du film conducteur.

Plus particulièrement, le film isolant (IS) est destiné à être situé sous la première zone (Z1) en séparant le film photovoltaïque (PV) de la deuxième zone (Z2), le film isolant recouvrant préférentiellement un bord du film photovoltaïque (PV), en regard de la deuxième zone précitée (Z2).

Dans un premier mode de réalisation :
- le film isolant est appliqué au moins sur la face avant du substrat entre les étapes a) et b), et
- le substrat est découpé à l'étape c) sous le film isolant.

Dans une première variante:
- avant l'étape b), la face avant du substrat est gravée sur une partie seulement de l'épaisseur du substrat, pour former une ébauche de la découpe du substrat de l'étape c),
- après l'opération de gravure, le film isolant est appliqué sur la face avant du substrat, au niveau de la gravure, et
- après l'étape d'encapsulation, la découpe du substrat est complétée sur toute l'épaisseur du substrat.

Dans une autre variante encore :
- avant l'étape b), le substrat est découpé localement seulement, sur une zone du substrat correspondant à la première zone précitée, et sensiblement plus longue que la première zone, et
- après l'étape d'encapsulation, la découpe du substrat est complétée au-delà de cette première zone.

Avantageusement, on prévoit en outre:
- une opération de test de fonctionnement de chaque cellule du panneau, et
- en cas de défaillance d'une cellule testée, une opération de mise en court-circuit de la cellule défaillante en comblant par un matériau conducteur la découpe du substrat réalisée à l'étape c) pour former la cellule défaillante.

Ainsi, la présence d'une cellule défaillante parmi les cellules du panneau n'altère pas le fonctionnement futur du panneau complet et ne nécessite pas non plus d'ôter mécaniquement cette cellule défaillante hors du panneau.

La présente invention vise aussi un panneau de cellules photovoltaïques selon la revendication 11 obtenu par la mise en oeuvre du procédé ci-avant. Le film conducteur d'une cellule comporte une couche de collecte de charges issues du film photovoltaïque, appliquée sur la face avant du film photovoltaïque, et la couche de collecte recouvre au moins partiellement le film photovoltaïque en s'étendant au-delà du film photovoltaïque sur de première et deuxième zones, la deuxième zone étant plus espacée du film photovoltaïque que la première zone. En particulier :
- ladite deuxième zone recouvre la face avant du substrat en étant en contact avec celui-ci, et
- le substrat présente un découpage au moins sous cette première zone.

On comprendra ainsi qu'il s'agit d'une carectéristique du panneau obtenu par la mise en oeuvre du procédé ci-avant.

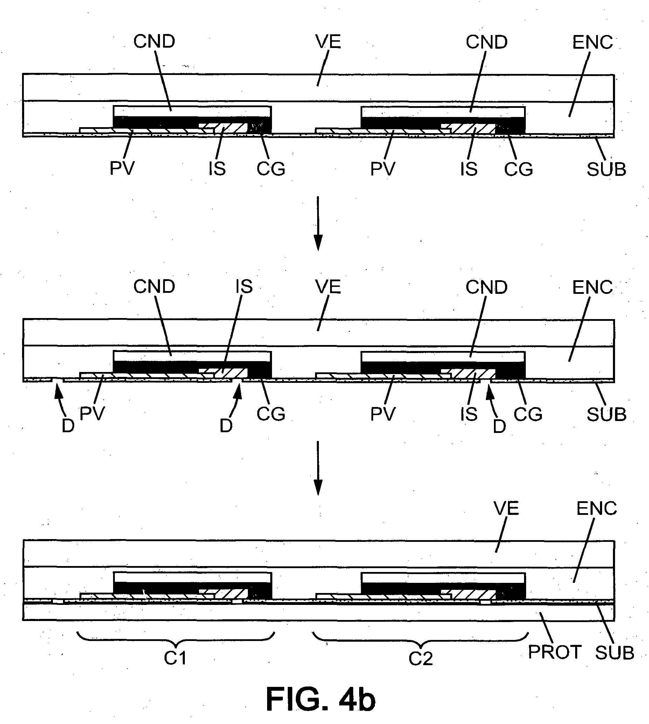

Cette caractéristique peut être visible notamment par comparaison de la figure la et de la figure 4b décrite plus loin.

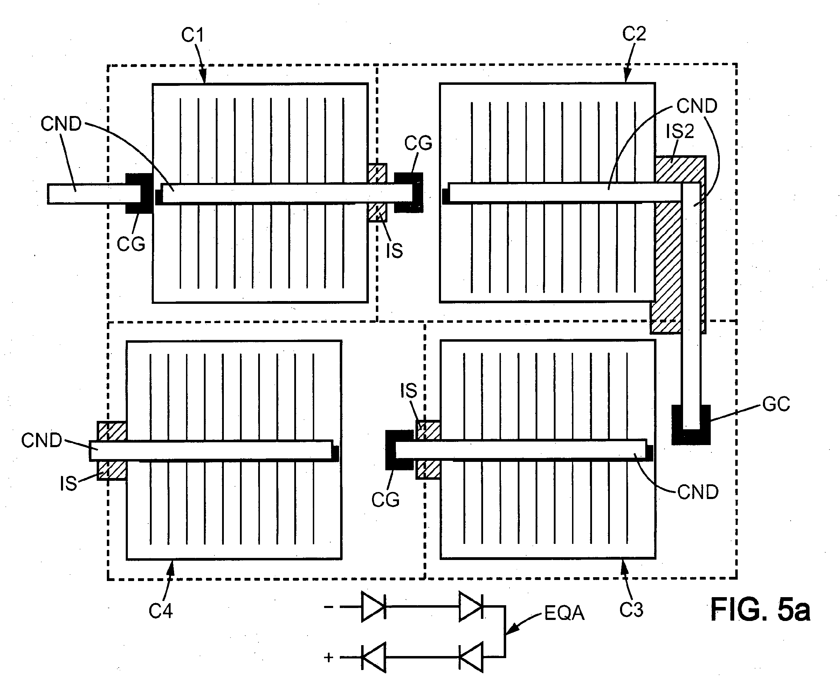

Comme on le verra aussi en référence aux figures 5a à 5c, la découpe du substrat peut avantageusement suivre un motif choisi correspondant à un schéma électrique prédéterminé d'interconnexion entre cellules (en série, en parallèle, en parallèle/série, etc.). En particulier, un motif de découpe entourant complètement une cellule peut correspondre à une mise en série de cette cellule.

D'autres avantages et caractéristiques de l'invention apparaîtront à la lecture de la description d'exemples possibles de réalisation donnés ci-après et à l'examen des dessins annexés, sur lesquels, outre les figures 1 et 1a commentées ci-avant:
- la figure 2 illustre schématiquement et partiellement une vue en coupe d'un ensemble de deux cellules au sens de l'invention,
- la figure 3 est une vue de dessus des cellules représentées sur la figure 2,
- les figures 4a et 4b illustrent des étapes du procédé au sens de l'invention, dans un exemple de réalisation,
- les figures 5a, 5b et 5c illustrent respectivement des schémas électriques possibles de mise en connexion des cellules d'un ensemble de cellules au sens de l'invention,
- les figures 6a et 6b illustrent des variantes respectives de réalisation du procédé des figures 4a et 4b,
- la figure 7 illustre un exemple de mise en court-circuit d'une cellule défaillante C d'un ensemble de cellules au sens de l'invention, et
- la figure 8 présente un exemple de réalisation possible de panneau photovoltaïque.

On se réfère tout d'abord à la figure 2, sur laquelle on a représenté complètement une cellule C1 et partiellement une cellule C2 immédiatement adjacente, reposant sur un même substrat métallique portant la référence SUB. En particulier, chaque cellule C1 comporte:
- film photovoltaïque PV, et
- au moins un film conducteur CND, pouvant interconnecter deux cellules C1 et C2 entre elles, comme décrit ci-après.

Ce film conducteur CND recouvre au moins partiellement la face avant du film photovoltaïque PV et s'étend au-delà du film photovoltaïque PV pour venir en contact avec le substrat SUB. En particulier, le film conducteur CND s'étend au-delà du film photovoltaïque PV sur :
- une première zone Z1, qui se poursuit par
- une deuxième zone Z2,
la deuxième zone Z2 étant plus distante du film photovoltaïque PV que la première zone Z1.

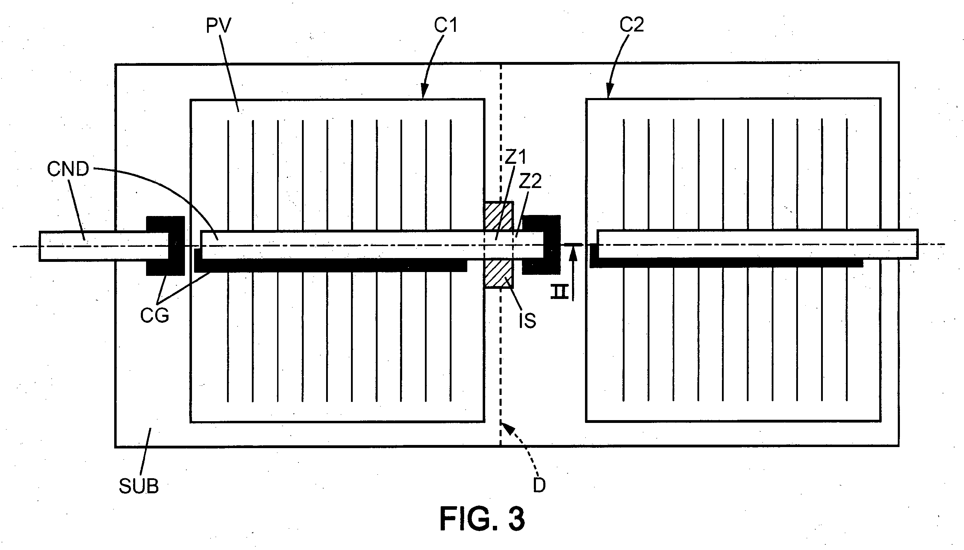

En réalité, comme on le verra en référence à la figure 3, le film conducteur CND recouvre partiellement seulement le film photovoltaïque PV pour ne pas cacher la lumière incidente sur le film photovoltaïque PV.

Au sens de l'invention, les cellules C1, C2 sont conservées sur un même support matérialisé ici par le substrat métallique SUB, commun à toutes les cellules, les films photovoltaïques PV de chaque cellule recouvrant le substrat métallique commun SUB. Comme on le verra en référence à la figure 3, les films PV à propriétés photovoltaïques des cellules n'occupent pas toute la surface du substrat métallique SUB, mais le recouvrent en partie seulement, une partie complémentaire de la surface du substrat SUB étant réservée notamment aux connexions comme décrit ci-après.

En particulier, dans la cellule C1 à interconnecter avec la cellule adjacente C2, la deuxième zone précitée Z2 recouvre le substrat commun SUB et vient en contact avec ce dernier. En outre, le substrat SUB est découpé et présente alors un espace vide D notamment sous la première zone Z1. Sans cet espace vide D, la cellule C1 par exemple est court-circuitée par le substrat métallique SUB. En découpant le substrat et en créant ainsi cet espace vide D, la circulation d'un courant électrique entre les films photovoltaïques PV respectives des cellules C1 et C2 s'effectue alors comme représenté par les flèches de la figure 2, depuis la face avant du film PV de la cellule C1,via:
- le film conducteur CND,
- sa première zone Z1,
- sa deuxième zone Z2,
- une partie du substrat métallique SUB,
jusqu'à la face arrière du film PV de la cellule C2.

L'espace vide D de la figure 2 peut être réalisé simplement par gravure locale du substrat SUB. Comme on le verra dans les exemples d'interconnexion de cellules décrits plus loin, une telle découpe D du substrat, lorsqu'elle est agencée tout autour de la cellule C1, permet déjà de dé-court-circuiter la cellule C1 de la cellule C2, par exemple selon une connexion série dans la représentation de la figure 3.

Il faut s'assurer toutefois que le film photovoltaïque PV ne va pas déborder au-delà de l'espace vide D et, en particulier, ne va pas venir en contact avec le substrat SUB à proximité de la cellule C2 (à droite de l'espace vide D comme représenté dans l'exemple de la figure 2). A cet effet, on prévoit un film isolant IS, recouvrant l'espace vide D en séparant le film PV de la deuxième zone Z2.

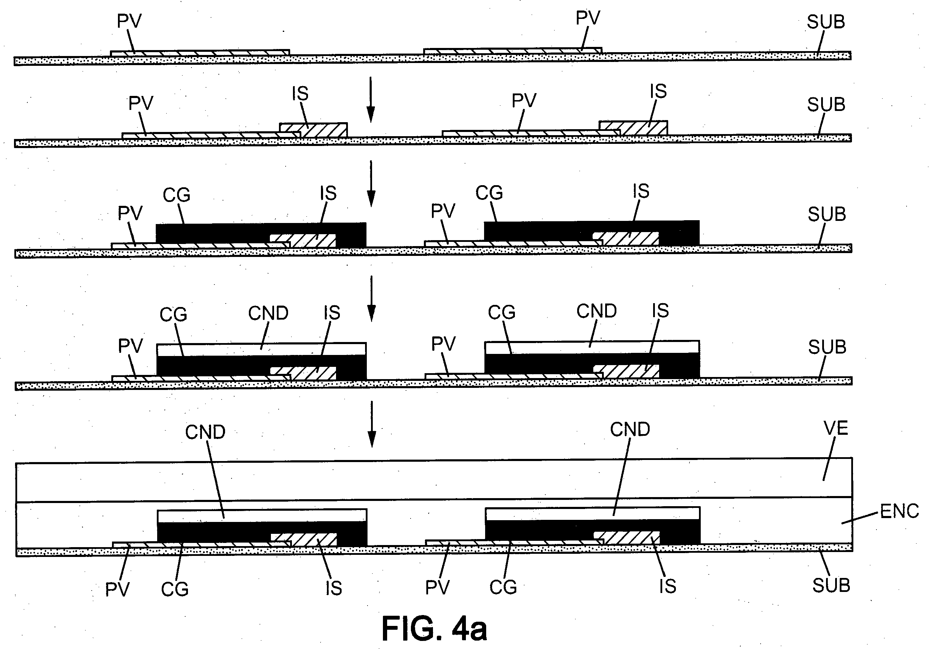

Comme indiqué précédemment, une grille de collecte est habituellement prévue pour récupérer les charges issues du film photovoltaïque PV. En référence à nouveau à la figure 2, le film conducteur CND comporte préférentiellement un sous-film CG possédant de telles propriétés de collecte de charges issues du film photovoltaïque PV. Un exemple de film de grille de collecte sera décrit de façon plus détaillée ci-après, en référence aux figures 4a à 4c.

Ainsi, comme représenté sur la figure 2:
- la découpe du substrat SUB peut être considérée ici comme ayant une fonction d'isolation entre le film photovoltaïque PV de la cellule C1 et du film photovoltaïque PV de la cellule C2,
- tandis que l'extension du film conducteur CND, au niveau de la deuxième zone Z2, a une fonction de connexion entre les deux films photovoltaïques PV.

Comme on le verra ci-après en référence à la figure 3 et aux figures 5a à 5c, la découpe du substrat commun SUB suit ainsi un motif choisi correspondant à un schéma électrique prédéterminé d'interconnexion des cellules.

On a représenté sur la figure 3 le cas d'une interconnexion de deux cellules C1 et C2 en série, la flèche Il de cette figure 3 désignant le plan de coupe de la figure 2. Les références de la figure 3 désignent donc les mêmes éléments que ceux de la figure 2. En particulier, la référence D désigne l'espace vide formé dans le substrat SUB. Cet espace vide D est représenté ici sous la forme d'un sillon séparant donc les deux cellules C1 et C2.

Toutefois, le motif de sillon D pour l'isolation entre cellule, comme le motif de la zone d'extension Z2 pour l'interconnexion entre cellules, peut être choisi en fonction d'un schéma électrique prédéterminé d'interconnexion des cellules.

On a représenté sur la figure 5a un motif de découpe (en traits pointillés) approprié pour la connexion en série de quatre cellules C1 à C4, dont le schéma équivalent est donné par la référence EQA. On notera que le film isolant de la cellule C2, référencé IS2, se prolonge jusqu'au sillon formé dans le substrat entre les cellules C2 et C3. Un motif de découpe entourant complètement une cellule (C1 par exemple) correspond à une connexion en série de cette cellule (C1) avec une cellule adjacente (C2 par exemple).

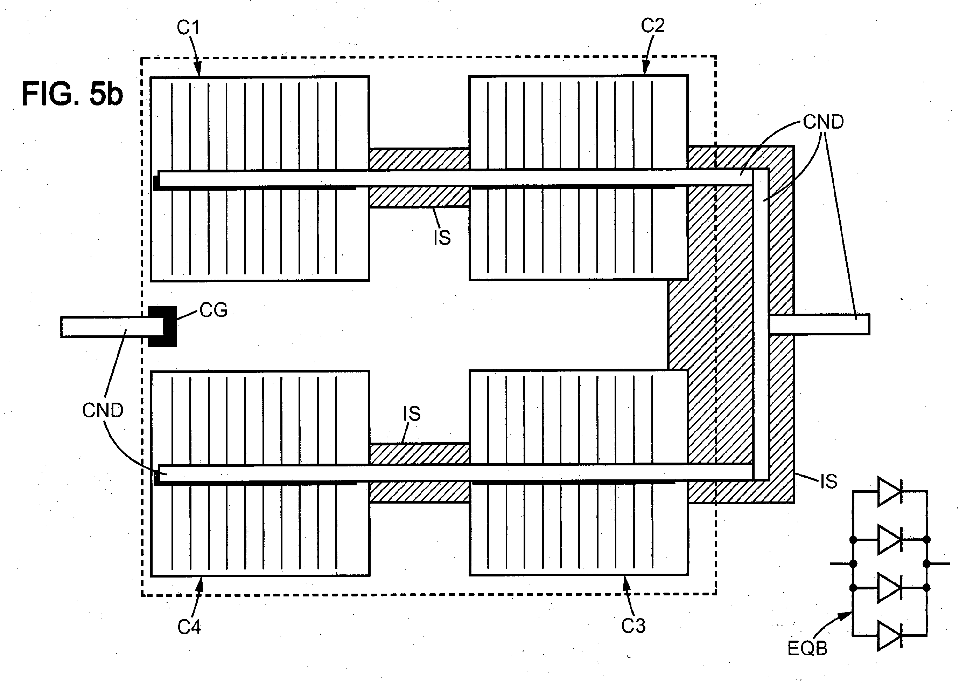

Sur la figure 5b, dans un autre exemple de réalisation possible, les quatre cellules représentées C1 à C4 sont connectées en parallèle selon le schéma équivalent EQB de cette figure.

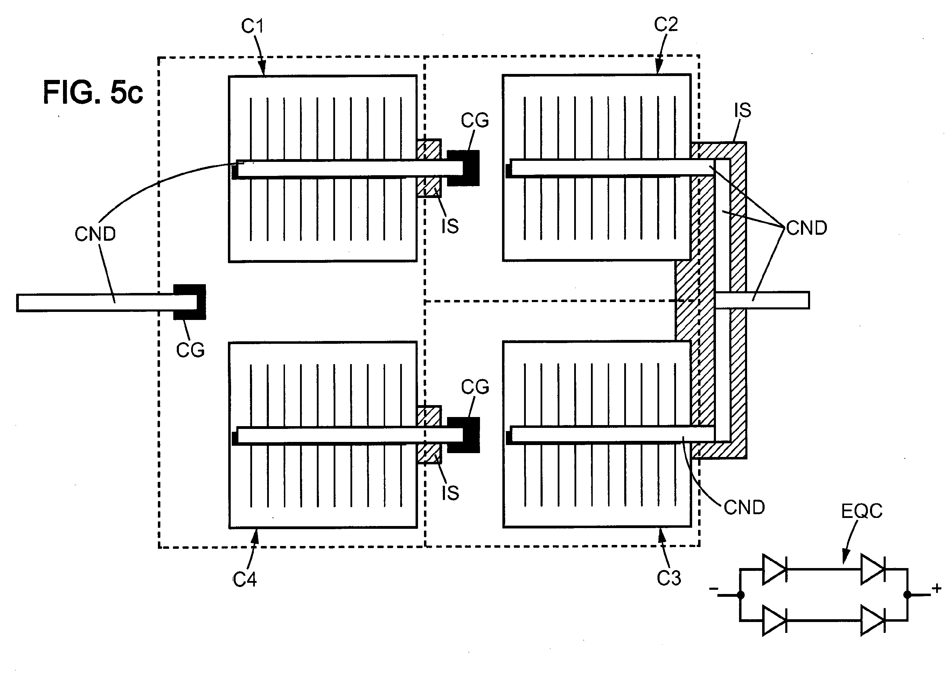

Dans l'exemple de la figure 5c, les quatre cellules représentées C1 à C4 sont connectées selon un schéma EQC parallèle/série, les cellules C1 et C2 étant connectées en série, ainsi que les cellules C4 et C3.

On se réfère maintenant aux figures 4a et 4b pour décrire un exemple de réalisation possible d'un procédé de fabrication d'un ensemble de cellules C1, C2 représenté par exemple sur la figure 2.

On obtient initialement les films photovoltaïques PV sur le substrat métallique commun SUB comme représenté sur le premier schéma du haut de la figure 4a. Par exemple, le substrat SUB peut être une feuille métallique fine (50 à 100µm) en acier, en cuivre ou en aluminium. On peut réaliser le dépôt d'une couche d'adaptation de molybdène (non représentée) avant le dépôt de la couche active à propriétés photovoltaïques PV, sur le substrat. Ce (ou ces) dépôt(s) peut (peuvent) être effectué(s) par exemple par électrolyse puisque le substrat SUB est conducteur et peut donc accueillir ce(s) dépôt(s) par électrolyse. La couche photovoltaïque PV peut être déposée aussi par électrolyse et peut être réalisée dans un composé I-III-VI₂ comme expliqué précédemment. Bien entendu, la présente invention s'applique aussi à tout autre type de dépôt, et à tout type de matériau photovoltaïque.

On dépose ensuite sélectivement, dans un premier temps dans cet exemple de réalisation, un film isolant IS à cheval entre le film photovoltaïque PV et la face avant du substrat SUB, en recouvrant un bord du film photovoltaïque PV et une partie adjacente de la face avant du substrat SUB. On applique ensuite un film conducteur par exemple sous la forme d'une couche de grille de collecte CG, continument:
- sur une partie de la face avant du film photovoltaïque PV,
- sur le film isolant IS et,
- au-delà du film isolant IS sur une partie de la face avant du substrat SUB adjacente à l'isolant IS.

Le film de grille de collecte CG (conducteur, bien entendu) peut, en soi, suffire déjà à lui seul à interconnecter les cellules. Il peut se présenter sous la forme d'une pâte métallique de sérigraphie comportant de l'argent liquide et qui peut être recuite pour sécher. Optionnellement, on prévoit ici en outre un autre film conducteur CND qui est appliqué sur la face avant du film de collecte CG. Ce film CND peut se présenter simplement sous la forme d'un ruban métallique adhésif.

Le film IS, isolant, est destiné à recouvrir l'espace vide D présenté précédemment en référence à la figure 2 notamment, en séparant le film photovoltaïque PV de la deuxième zone Z2 du conducteur CG. Ainsi, le film isolant IS est, dans l'empilement, entre le film photovoltaïque PV et le film conducteur CG et/ou CND (sous la première zone Z1 de la figure 2). Préférentiellement, dans un mode de réalisation pratique du procédé au sens de l'invention, le film isolant 1S recouvre partiellement le film photovoltaïque PV. En effet, pour s'assurer que le bord latéral du film PV est bien isolé de la grille de collecte CG, on procède à un dépôt de l'isolant IS en recouvrant complètement le bord latéral du film photovoltaïque PV.

A ce stade, une encapsulation ENC de la face avant (haut de la figure 4a) de l'ensemble des films et substrat est menée. Son but est notamment:
- d'une part, de protéger les dépôts en appliquant par exemple une plaque de verre VE (ou tout autre matériau protecteur transparent) encollé à un matériau d'encapsulation tel que par exemple un polymère tel que l'EVA (éthylène vinyle acétate) ou le PVB (polyvinyle-butyral),
- d'autre part, de maintenir mécaniquement l'ensemble en un seul bloc lorsque l'étape de découpe du substrat est appliquée, comme décrit maintenant en référence à la figure 4b.

En effet, on a vu précédemment, notamment en référence à la figure 3 ou à la figure 5a, que le substrat pouvait être découpé tout autour de chaque cellule, ce qui aurait pu conduire à une désolidarisation mécanique des cellules les unes des autres. On évite une telle désolidarisation, du fait de l'encapsulation de la face avant de l'ensemble, préalable au découpage du substrat.

Ainsi, en référence à la figure 4b, il apparaît qu'après l'encollage de la plaque de protection VE (premier schéma du haut de la figure 4b), la face arrière du substrat SUB est laissée libre. On applique alors un découpage du substrat SUB par sa face arrière, pour former les espaces vides D, notamment en dessous de l'isolant 1S de chaque cellule. On dé-court-circuite ainsi électriquement les cellules les unes des autres. Cette étape de découpage peut être menée par une technique de gravure par laser ou encore simplement par sciage mécanique, ou par attaque chimique, ou par tout autre type de technique permettant de ne pas attaquer au moins la grille de collecte CG au-dessus du film isolant IS. Une fois le substrat découpé et les cellules ainsi dé-court-circuitées, on applique ensuite un revêtement de protection PROT sur la face arrière du substrat SUB.

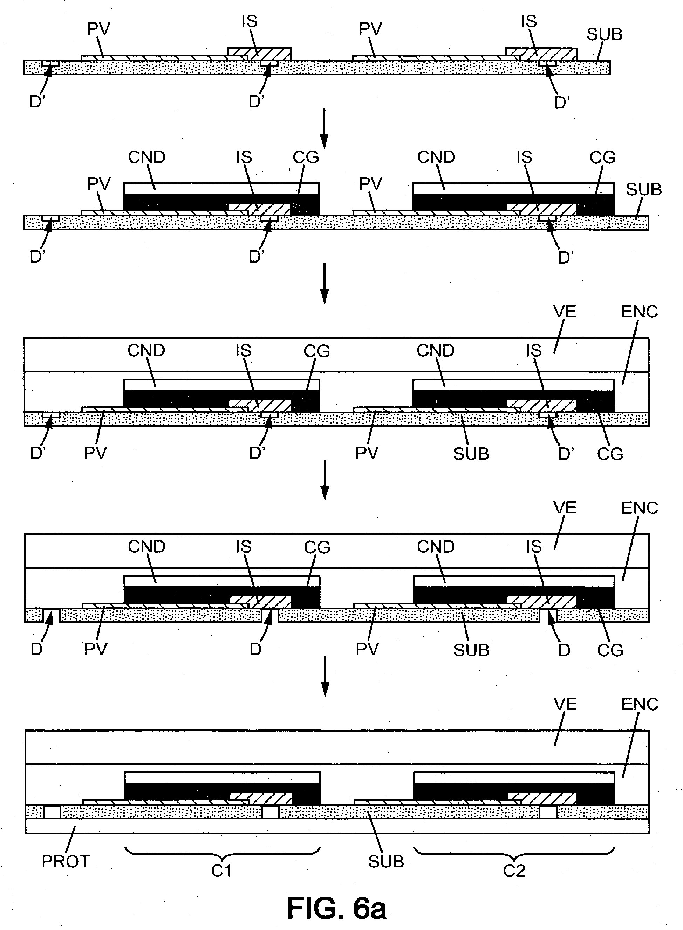

On se réfère maintenant à la figure 6a pour décrire une variante de réalisation dans laquelle on cherche en particulier à préserver autant que possible le film isolant IS et surtout la grille de collecte CG pendant l'étape de découpage du substrat SUB. En particulier, ici, le substrat est prédécoupé sur une partie seulement de son épaisseur (régions D' de la figure 6a), sur sa face avant. Les étapes suivantes d'obtention des films photovoltaïques PV, des isolants IS, de dépôt des grilles de collecte CG et de films conducteurs supplémentaires CND sont menées, jusqu'à l'encapsulation ENC de la face avant avec encollage de la plaque VE. Un découpage complémentaire est ensuite mené par la face arrière du substrat SUB, sur toute l'épaisseur du substrat pour créer les espaces vides D notamment sous les films isolants IS. On peut alors appliquer ensuite l'encollage d'une plaque de protection PROT sur la face arrière du substrat complètement découpé.

Par exemple, dans cette réalisation, le métal du substrat commun SUB peut être partiellement gravé par laser par la face avant, avant le dépôt du film d'isolation IS. Ensuite, la découpe complète du substrat peut être réalisée à une énergie laser plus basse, en fin de procédé, en réduisant ainsi le risque d'endommagement de la couche de collecte CG ou du ruban de connexion CND.

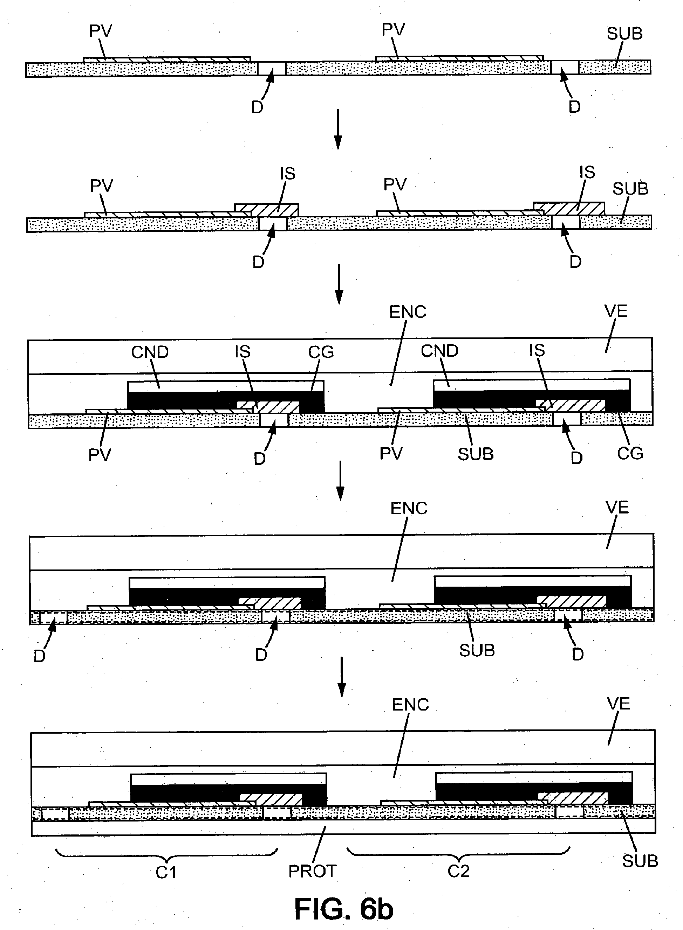

L'étape de découpe du substrat SUB peut donc être critique en présence en particulier de la grille de collecte CG, si elle risque d'être atteinte par la découpe du substrat. Ainsi, une autre variante consiste à découper toute l'épaisseur du substrat SUB, localement, avant le dépôt de l'isolant IS et de la grille de collecte CG sur le substrat, pour préserver la grille CG. On a représenté cette variante sur la figure 6b. Dans le procédé selon cette variante, le substrat SUB est prédécoupé localement seulement, dans les régions D du substrat destinées à accueillir les dépôts d'isolant IS et de couche de collecte CG. Les films photovoltaïques PV sont par ailleurs obtenus comme en début des procédés décrits ci-avant en référence aux figures 4a ou 6a. On dépose ensuite, sur les espaces vides D créés par les découpages locaux du substrat, l'isolant IS. On relèvera ici que le matériau du film isolant IS peut s'insinuer dans l'espace D. Toutefois, une telle éventualité est sans conséquence sur le fonctionnement final de la cellule, le but de l'espace D étant en effet d'isoler les deux parties de substrat de part et d'autre de cet espace D. La même remarque s'applique d'ailleurs lorsque le substrat n'est que partiellement prédécoupé en épaisseur (comme représenté sur le premier schéma du haut de la figure 6a). Ensuite, les autres étapes de dépôt de la grille de collecte CG et du conducteur CND et d'encapsulation ENC sont menées en laissant libre la face arrière du substrat SUB. Une fois ces étapes menées, on peut découper complètement le substrat par sa face arrière, par exemple sur tout le pourtour des cellules. Dans l'exemple de la figure 6b, on a illustré par des traits pointillés le fait que le substrat pouvait être découpé tout autour de chaque cellule C1, C2. Là encore, une fois le substrat complètement découpé, on peut procéder à l'encapsulation de la face arrière.

On relèvera aussi que ces solutions de procédés selon les figures 6a et 6b conservent la possibilité de maintenir mécaniquement toutes les cellules solidaires les unes des autres jusqu'à la fin du procédé.

Ainsi, le procédé au sens de l'invention permet avantageusement de conserver sur un même support matérialisé par le substrat SUB toutes les cellules photovoltaïques déposées sur ce support sans avoir à prévoir :
- une découpe individuelle systématique des cellules,
- une solidarisation sur un support commun de toutes les cellules,
- une création des contacts de chaque cellule,
- puis enfin une interconnexion des cellules.

Ici, le substrat SUB fait office de support mécanique des cellules jusqu'à l'encapsulation de la face avant du substrat.

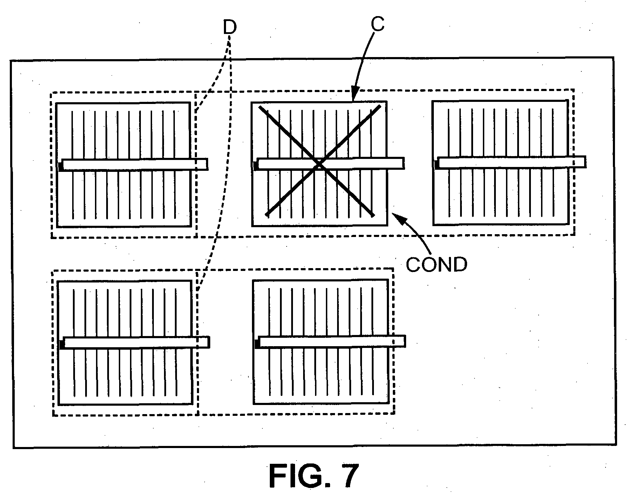

Toutefois, dans le procédé au sens de l'invention, il peut se poser le problème, en référence maintenant à la figure 7, d'une cellule C défaillante parmi l'ensemble des cellules. Ici, les cellules sont solidaires entre elles mécaniquement via le support commun. Or, la cellule défaillante C doit être éliminée électriquement. On surmonte cette difficulté comme suit:
- avant l'encapsulation de la face avant, on prévoit une opération de test de fonctionnement de chaque cellule, et
- en cas de défaillance d'une cellule testée, on effectue une opération de mise en court-circuit de la cellule défaillante en comblant par un matériau conducteur COND l'espace vide D sous la cellule défaillante C.

On peut prévoir par exemple de ressouder l'espace D de cette cellule C, ce qui a alors pour effet de court-circuiter son anode à sa cathode.

Bien entendu, la présente invention ne se limite pas à la forme de réalisation décrite ci-avant à titre d'exemple; elle s'applique à d'autres variantes.

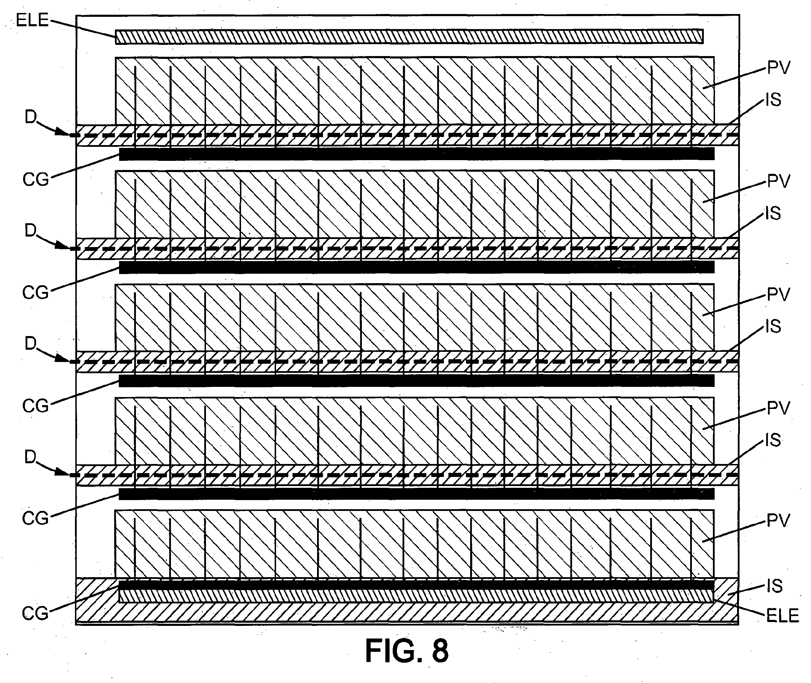

Ainsi, on comprendra que l'invention s'applique à tout type de matériau photovoltaïque PV ou isolant IS ou conducteur CG, CND, utilisé dans le procédé au sens de l'invention, et n'est aucunement limitée aux exemples de réalisation donnés ci-avant. De même, les formes géométriques des films représentés sur les figures, ainsi que leurs épaisseurs respectives, ne sont présentées qu'à titre d'exemples illustratifs. Par exemple, en référence à la figure 8, une forme possible des films photovoltaïques PV, variante de celle représentée sur les figures 1 à 7, consiste en une bandelette s'étendant sur toute la largeur du substrat. Chaque film PV est séparé d'un autre film PV adjacent par une découpe D du substrat sur laquelle est appliqué un film isolant IS. Une grille de collecte CG déposée sur chaque film PV comporte des doigts conducteurs qui viennent en contact avec le substrat métallique juste après l'espace découpé D. Un tel montage correspond à une connexion en série des cellules entre deux électrodes ELE (anode et cathode).

Par ailleurs, le ruban de connexion CND appliqué sur la couche de collecte CG a été décrit ci-avant à titre d'exemple et peut être optionnel. En effet, la couche de collecte CG, en contact avec le substrat SUB dans la zone Z2, suffit à interconnecter la face avant du film photovoltaïque PV au substrat, et de là, à la face arrière d'un film photovoltaïque d'une cellule adjacente. On relèvera d'ailleurs que la couche de collecte CG de l'art antérieur, comme représentée sur la figure la, n'a pas une telle fonction et qu'elle s'arrête simplement au film isolant IS. On ne retrouve donc pas dans l'art antérieur les zones Z1 et Z2 d'extension de la couche de collecte au-delà du film photovoltaïque PV, contrairement au cas de l'invention représenté notamment sur la figure 2. On comprendra alors que cette extension de la couche de collecte CG sur le substrat SUB est une caractéristique du panneau obtenu par la mise en oeuvre du procédé.

## Revendications

1. Procédé de fabrication d'un panneau de cellules photovoltaïques, comportant les étapes :
a) obtention de films photovoltaïques (PV) destinés chacun à une cellule, disposés sur une face avant d'un substrat métallique (SUB),
b) application d'au moins un film conducteur (CG, CND) sur chaque face avant d'un film photovoltaïque (PV),
c) découpe du substrat (SUB) pour isoler des cellules les unes des autres,
d) encapsulation (ENC) des cellules sur un support commun,
dans lequel les étapes d) et c) sont inversées, l'étape d) visant une encapsulation de la face avant du substrat, avant la découpe du substrat par sa face arrière à l'étape c), et dans lequel :
- avant l'étape b), un film isolant (IS) est appliqué, ledit film isolant étant adjacent au film photovoltaïque (PV), d'épaisseur supérieure à celle du film photovoltaïque et recouvrant partiellement ledit film photovoltaïque, et
- à l'étape b), une zone (Z1, Z2) du film conducteur se prolonge sur le substrat de sorte que le film conducteur est en contact à la fois avec la face avant du film photovoltaïque et la face avant du substrat, les films photovoltaïques étant court-circuités entre eux par le substrat métallique à cette étape b),
- à l'étape c), le substrat est découpé pour dé-court-circuiter les films photovoltaïques entre eux, au moins sous ladite zone du film conducteur et sur une largeur de substrat inférieure à la largeur de la zone,
ladite zone de film conducteur, combinée au substrat, reliant électriquement la face avant du film photovoltaïque à la face arrière d'un film photovoltaïque d'une cellule adjacente et ledit film isolant étant situé au-dessus de la découpe du substrat et sous une partie de la zone d'extension (Z1) du film conducteur.

2. Procédé selon la revendication 1, **caractérisé en ce que** le film conducteur comporte une grille de collecte (CG) de charges issues du film photovoltaïque (PV), appliquée sur la face avant du film photovoltaïque (PV).

3. Procédé selon la revendication 2, **caractérisé en ce que** le film conducteur comporte en outre un ruban conducteur (CND) appliqué sur la grille de collecte et recouvrant ladite zone (Z1,Z2) pour être en contact avec la face avant du substrat.

4. Procédé selon l'une des revendications précédentes, **caractérisé en ce que** le film conducteur (CND) recouvre au moins partiellement le film photovoltaïque (PV) en s'étendant au-delà du film photovoltaïque (PV) sur de première et deuxième zones (Z1, Z2), la deuxième zone (Z2) étant plus espacée du film photovoltaïque (PV) que la première zone (Z1), et **en ce que**:
- ladite deuxième zone (Z2) recouvre la face avant du substrat (SUB) en étant en contact avec le substrat (SUB), et
- le substrat (SUB) est découpé en présentant un espace vide (D) sous ladite première zone (Z1).

5. Procédé selon la revendication 4, **caractérisé en ce que** le film isolant (IS) est destiné à être situé sous ladite première zone (Z1) en séparant le film photovoltaïque (PV) de la deuxième zone (Z2).

6. Procédé selon la revendication 5, **caractérisé en ce que** le film isolant recouvre un bord du film photovoltaïque (PV), en regard de ladite deuxième zone (Z2).

7. Procédé selon l'une des revendications 5 et 6, **caractérisé en ce que**:
- le film isolant (IS) est appliqué au moins sur la face avant du substrat entre les étapes a) et b), et
- le substrat est découpé à l'étape c) sous le film isolant (IS).

8. Procédé selon l'une des revendications 5 et 6, **caractérisé en ce que** :
- avant l'étape b), la face avant du substrat (SUB) est gravée sur une partie de l'épaisseur du substrat, pour former une ébauche de la découpe du substrat de l'étape c),
- après l'opération de gravure, le film isolant (IS) est appliqué sur la face avant du substrat (SUB), et
- après l'étape d'encapsulation, la découpe du substrat est complétée sur toute l'épaisseur du substrat.

9. Procédé selon l'une des revendications 5 et 6, **caractérisé en ce que** :
- avant l'étape b), le substrat est découpé localement sur une zone du substrat correspondant à ladite première zone (Z1), et sensiblement plus longue que la première zone (Z1), et
- après l'étape d'encapsulation, la découpe du substrat est complétée au-delà de ladite première zone (Z1).

10. Procédé selon l'une des revendications précédentes, **caractérisé en ce qu'**il comporte en outre :
- une opération de test de fonctionnement de chaque cellule du panneau, et
en cas de défaillance d'une cellule testée, une opération de mise en court-circuit de la cellule défaillante en comblant par un matériau conducteur la découpe (D) du substrat réalisée à l'étape c) pour former la cellule défaillante.

11. Panneau de cellules photovoltaïques, comportant :
- un substrat métallique (SUB),
- au moins des premier et deuxième films photovoltaïques disposés sur une face avant d'un substrat métallique (SUB),
- un film isolant (IS) adjacent au premier film photovoltaïque (PV), d'épaisseur supérieure à celle du film photovoltaïque et recouvrant partiellement ledit premier film photovoltaïque,
- un film conducteur (CG, CND) comportant une couche de collecte (CG) de charges issues du premier film photovoltaïque (PV), la couche de collecte (CG) recouvrant au moins partiellement le premier film photovoltaïque (PV) en s'étendant au-delà du premier film photovoltaïque (PV) sur de première et deuxième zones (Z1, Z2), le film isolant (IS) étant situé sous la première zone (Z1) en séparant le film photovoltaïque (PV) de la deuxième zone (Z2), de sorte que le film conducteur (CG, CND) recouvre la face avant du substrat (SUB) en étant en contact avec le substrat (SUB) au niveau de la deuxième zone (Z2), et
- une encapsulation (ENC) des cellules photovoltaïques,
**caractérisé en ce que** le substrat (SUB) présente une découpe (D) pour dé-court-circuiter les films photovoltaïques entre eux, au moins sous ladite première zone (Z1) et sur une largeur de substrat inférieure à la largeur de ladite première zone (Z1), et **en ce que** ledit film isolant (IS) est situé au-dessus de la découpe (D) et sous une partie de la première zone (Z1) du film conducteur.

12. Panneau selon la revendication 11, **caractérisé en ce que** la découpe (D) du substrat (SUB) suit un motif choisi correspondant à un schéma électrique prédéterminé d'interconnexion entre cellules, et **en ce qu'**un motif de découpe entourant une cellule correspond à une mise en série de ladite cellule.

## Patentansprüche

1. Verfahren zur Herstellung einer Platte von Photovoltaikzellen, umfassend die folgenden Schritte:
a) Gewinnung von Photovoltaikfolien (PV), die jeweils für eine Zelle bestimmt und auf einer Vorderseite eines metallischen Substrats (SUB) angeordnet sind,
b) Aufbringen mindestens einer leitenden Folie (CG, CND) auf jede Vorderseite einer Photovoltaikfolie (PV),
c) Schneiden des Substrats (SUB), um Zellen voneinander zu isolieren,
d) Verkapselung (ENC) der Zellen auf einem gemeinsamen Träger,
wobei die Schritte d) und c) umgekehrt werden, wobei Schritt d) eine Verkapselung der Vorderseite des Substrats vor dem Schneiden des Substrats von seiner Rückseite in Schritt c) vorsieht,
und wobei:
- vor dem Schritt b) eine Isolierfolie (IS) aufgebracht wird, wobei die Isolierfolie an die Photovoltaikfolie (PV) mit einer größeren Dicke als jene der Photovoltaikfolie angrenzt und teilweise die Photovoltaikfolie bedeckt,
und
- sich in Schritt b) eine Zone (Z1, Z2) der leitenden Folie auf dem Substrat verlängert, so dass die leitende Folie sowohl mit der Vorderseite der Photovoltaikfolie als auch mit der Vorderseite des Substrats in Kontakt ist, wobei die Photovoltaikfolien durch das metallische Substrat in diesem Schritt b) miteinander kurzgeschlossen werden,
- in Schritt c) das Substrat geschnitten wird, um die Photovoltaikfolien mindestens unter der Zone der leitenden Folie und auf einer geringeren Substratbreite als der Breite der Zone voneinander ent-kurzzuschließen,
wobei die Zone der leitenden Folie in Kombination mit dem Substrat die Vorderseite der Photovoltaikfolie mit der Rückseite einer Photovoltaikfolie einer angrenzenden Zelle elektrisch verbindet, und wobei die Isolierfolie über dem Schnitt des Substrats und unter einem Teil der Erweiterungszone (Z1) der leitenden Folie angeordnet ist.

2. Verfahren nach Anspruch 1, **dadurch gekennzeichnet, dass** die leitende Folie ein Sammelgitter (CG) für von der Photovoltaikfolie (PV) kommende Ladungen umfasst, das auf die Vorderseite der Photovoltaikfolie (PV) aufgebracht ist.

3. Verfahren nach Anspruch 2, **dadurch gekennzeichnet, dass** die leitende Folie ferner ein leitendes Band (CND) umfasst, das auf das Sammelgitter aufgebracht ist und die Zone (Z1, Z2) bedeckt, um mit der Vorderseite des Substrats in Kontakt zu sein.

4. Verfahren nach einem der vorhergehenden Ansprüche, **dadurch gekennzeichnet, dass** die leitende Folie (CND) zumindest teilweise die Photovoltaikfolie (PV) bedeckt, wobei sie sich über die Photovoltaikfolie (PV) hinaus auf einer ersten und zweiten Zone (Z1, Z2) erstreckt, wobei die zweite Zone (Z2) weiter von der Photovoltaikfolie (PV) entfernt ist als die erste Zone **(Z1),** und dass:
- die zweite Zone (Z2) die Vorderseite des Substrats (SUB) bedeckt, wobei sie mit dem Substrat (SUB) in Kontakt ist, und
- das Substrat (SUB) geschnitten wird, wobei es einen Leerraum (D) unter der ersten Zone (Z1) aufweist.

5. Verfahren nach Anspruch 4, **dadurch gekennzeichnet, dass** die Isolierfolie (IS) dazu bestimmt ist, unter der ersten Zone (Z1) angeordnet zu sein, wobei sie die Photovoltaikfolie (PV) von der zweiten Zone (Z2) trennt.

6. Verfahren nach Anspruch 5, **dadurch gekennzeichnet, dass** die Isolierfolie einen Rand der Photovoltaikfolie (PV) gegenüber der zweiten Zone (Z2) bedeckt.

7. Verfahren nach einem der Ansprüche 5 und 6, **dadurch gekennzeichnet, dass**:
- die Isolierfolie (IS) mindestens auf die Vorderseite des Substrats zwischen den Schritten a) und b) aufgebracht wird, und
- das Substrat in Schritt c) unter der Isolierfolie (IS) geschnitten wird.

8. Verfahren nach einem der Ansprüche 5 und 6, **dadurch gekennzeichnet, dass**:
- vor dem Schritt b) die Vorderseite des Substrats (SUB) auf einem Teil der Dicke des Substrats graviert wird, um einen Ansatz für den Schnitt des Substrats aus Schritt c) zu bilden,
- nach dem Gravieren die Isolierfolie (IS) auf die Vorderseite des Substrats (SUB) aufgebracht wird, und
- nach dem Verkapselungsschritt der Schnitt des Substrats auf der gesamten Dicke des Substrats ergänzt wird.

9. Verfahren nach einem der Ansprüche 5 und 6, **dadurch gekennzeichnet, dass**:
- vor dem Schritt b) das Substrat lokal auf einer Zone des Substrats geschnitten wird, die der ersten Zone (Z1) entspricht und wesentlich länger als die erste Zone (Z1) ist, und
- nach dem Verkapselungsschritt der Schnitt des Substrats über die erste Zone (Z1) hinaus ergänzt wird.

10. Verfahren nach einem der vorhergehenden Ansprüche, **dadurch gekennzeichnet, dass** es ferner umfasst:
- einen Funktionstest jeder Zelle der Platte, und im Falle einer Funktionsstörung einer getesteten Zelle ein Kurzschließen der fehlerhaften Zelle, wobei der Schnitt (D) des Substrats, der in Schritt c) hergestellt wurde, mit einem leitenden Material gefüllt wird, um die fehlerhafte Zelle zu bilden.

11. Platte mit Photovoltaikzellen, umfassend:
- ein metallisches Substrat (SUB),
- mindestens erste und zweite Photovoltaikfolien, die auf einer Vorderseite eines metallischen Substrats (SUB) angeordnet sind,
- eine Isolierfolie (IS), die an die erste Photovoltaikfolie (PV) mit einer größeren Dicke als jene der Photovoltaikfolie angrenzt und teilweise die erste Photovoltaikfolie bedeckt,
- eine leitende Folie (CG, CND), umfassend eine Sammelschicht (CG) für von der ersten Photovoltaikfolie (PV) kommende Ladungen, wobei die Sammelschicht (CG) mindestens teilweise die erste Photovoltaikfolie (PV) bedeckt, wobei sie sich über die erste Photovoltaikfolie (PV) hinaus auf einer ersten und zweiten Zone (Z1, Z2) erstreckt, wobei die Isolierfolie (IS) unter der ersten Zone (Z1) angeordnet ist, wobei sie die Photovoltaikfolie (PV) von der zweiten Zone (Z2) trennt, so dass die leitende Folie (CG, CND) die Vorderseite des Substrats (SUB) bedeckt, wobei sie mit dem Substrat (SUB) im Bereich der zweiten Zone (Z2) in Kontakt ist, und
- eine Verkapselung (ENC) der Photovoltaikzellen,
**dadurch gekennzeichnet, dass** das Substrat (SUB) einen Schnitt (D) aufweist, um die Photovoltaikfolien mindestens unter der ersten Zone (Z1) und auf einer geringeren Substratbreite als die Breite der ersten Zone (Z1) voneinander ent-kurzzuschließen, und dass die Isolierfolie (IS) über dem Schnitt (D) und unter einem Teil der ersten Zone (Z1) der leitenden Folie angeordnet ist.

12. Platte nach Anspruch 11, **dadurch gekennzeichnet, dass** der Schnitt (D) des Substrats (SUB) einem ausgewählten Motiv entsprechend einem vorbestimmten elektrischen Schema des Zusammenschlusses zwischen Zellen folgt, und dass ein Schnittmotiv, das eine Zelle umgibt, einer Serienschaltung der Zelle entspricht.

## Claims

1. Method for manufacturing a panel of photovoltaic cells, comprising the steps of:
a) obtaining photovoltaic films (PV) each intended for a cell, arranged on a front surface of a metal substrate (SUB),
b) applying at least one conductive film (CG, CND) on each front surface of a photovoltaic film (PV),
c) cutting the substrate (SUB) to isolate cells from one another,
d) encapsulating (ENC) the cells on a common support,
wherein the steps d) and c) are reversed, with step d) encapsulating the front surface of the substrate prior to the substrate being cut through its rear surface in step c),
and wherein:
- prior to step b), an insulating film (IS) is applied, said insulating film being adjacent to the photovoltaic film (PV), having a thickness greater than that of the photovoltaic film, and partially covering said photovoltaic film, and
- in step b), an area (Z1, Z2) of the conductive film is extended over the substrate such that the conductive film simultaneously makes contact with both the front surface of the photovoltaic film and the front surface of the substrate, the photovoltaic films being short-circuited together by the metal substrate at that step b),
- in step c), the substrate is cut so as to avoid short-circuiting between the photovoltaic films, at least under said area of the conductive film and over a substrate width less than the width of the area,
said area of the conductive film, combined with the substrate, electrically connecting the front surface of the photovoltaic film to the rear surface of a photovoltaic film of an adjacent cell and insulating film being located above the cut of the substrate and under a part of the extension area (Z1) of the conductive film.

2. Method according to Claim 1, wherein the conductor film comprises a collector grid (CG) for charges emanating from the photovoltaic film (PV), applied to the front surface of the photovoltaic film (PV).

3. Method according to Claim 2, wherein the conductive film further comprises a conductive strip (CND) applied to the collector grid and covering said area (Z1,Z2) in order to come in contact with the front surface of the substrate.

4. Method according to any of the preceding claims, wherein the conductive film (CND) at least partially covers the photovoltaic film (PV), extending beyond the photovoltaic film (PV) into first and second areas (Z1, Z2), the second area (Z2) further away from the photovoltaic film (PV) than the first area (Z1), and wherein:
- said second area (Z2) covers the front surface of the substrate (SUB) and is in contact with the substrate (SUB), and
- the substrate (SUB) is cut to have an empty space (D) below said first area (Z1).

5. Method according to Claim 4, wherein the insulating film (IS) is intended to be located below said first area (Z1), separating the photovoltaic film (PV) from the second area (Z2).

6. Method according to Claim 5, wherein the insulating film covers one edge of the photovoltaic film (PV), opposite said second area (Z2).

7. Method according to either of Claims 5 or 6, wherein:
- the insulating film (IS) is applied to at least the front surface of the substrate between steps a) and b), and
- the substrate is cut in step c) below the insulating film (IS).

8. Method according to either of Claims 5 or 6, wherein:
- before step b), the front surface of the substrate (SUB) is etched, for less than the entire thickness of the substrate, to form a template of the cut in the substrate from step c),
- after the etching operation, the insulating film (IS) is applied to the front surface of the substrate (SUB), and
- after the encapsulation step, the cutting of the substrate is completed through the entire thickness of the substrate.

9. Method according to either of Claims 5 or 6, wherein:
- before step b), the substrate is cut locally in one area of the substrate corresponding to the aforesaid first area (Z1), and substantially longer than the first area (Z1), and
- after the encapsulation step, the cutting of the substrate is completed beyond said first area (Z1).

10. Method according to any of the preceding claims, **characterized by** further comprising:
- a functional testing of the operation of each cell of the panel, and
- in the event a tested cell fails, a short-circuiting operation on the faulty cell by filling with a conductive material the cut (D) in the substrate made in step c) to form the faulty cell.

11. Panel of photovoltaic cells, comprising:
- a metal substrate (SUB),
- at least first and second photovoltaic films arranged on a front face of a metal substrate (SUB),
- an insulating film (IS) adjacent to the first photovoltaic film (PV) and having a thickness greater than that of the photovoltaic film, and partially covering said photovoltaic film,
- a conductive film (CG, CND) comprising a collector layer (CG) for collecting charges emanating from the photovoltaic film (PV), the collector layer (CG) at least partially covering the photovoltaic film (PV), extending beyond the photovoltaic film (PV) over first and second areas (Z1, Z2), the insulating film (IS) being located under the first area (Z1) separating the photovoltaic film (PV) from the second area (Z2), so that the conductive film (CG, CND) covers the front face of the substrate (SUB) and contacts the substrate (SUB) near the second area (Z2), and
- an encapsulation (ENC) of the photovoltaic cells,
**Characterized in that** the substrate (SUB) has a cut (D) for avoiding a short-circuit of the photovoltaic films between them, at least under said first area (Z1) and over a substrate width less than the width of the first area (Z1), and **in that** the insulating film (IS) is located above the cut (D) and under a part of the first area (Z1) of the conductive film.

12. Panel according to Claim 11, wherein the cutting in the substrate (SUB) follows a chosen pattern corresponding to a predetermined wiring diagram for interconnection between cells, and wherein a cutting pattern surrounding a cell corresponds to placing said cell in a series configuration.
